**Europäisches Patentamt**

**European Patent Office**

**Office européen des brevets**

(11) Veröffentlichungsnummer: **0 158 588**
**A2**

(12) **EUROPÄISCHE PATENTANMELDUNG**

(21) Anmeldenummer: 85730049.5

(22) Anmeldetag: 01.04.85

(51) Int. Cl.⁴: **H 01 L 31/10**
**G 01 T 1/00**

(30) Priorität: 10.04.84 DE 3413829

(43) Veröffentlichungstag der Anmeldung:
16.10.85 Patentblatt 85/42

(84) Benannte Vertragsstaaten:
AT BE CH DE FR GB IT LI LU NL SE

(71) Anmelder: Hahn-Meitner-Institut für Kernforschung
Berlin GmbH
Glienicker Strasse 100
D-1000 Berlin 39(DE)

(72) Erfinder: Knoll, Meinhard, Dr.-Ing
Gasteiner Strasse 13
D-1000 Berlin 31(DE)

(72) Erfinder: Bräunig, Dietrich, Dr.-Ing
Franzensbader Strasse 14
D-1000 Berlin 33(DE)

(72) Erfinder: Fahrner, Wolfgang, Dr.rer.nat.
Glienicker Strasse 66
D-1000 Berlin 39(DE)

(74) Vertreter: Wolff, Konrad et al,
Heinrich-Hertz-Institut für Nachrichtentechnik Berlin
GmbH Einsteinufer 37
D-1000 Berlin 10(DE)

(54) MOS-dosimeter und Verfahren zu seiner Herstellung.

(57) Bei bekannten MOS-Dosimetern zur Messung der Energiedosis im Bereich von Strahlenfeldern, welche aus einem Halbleitersubstrat mit einer Isolatorschicht und einem Metallkontakt bestehen, beruht das Meßprinzip auf einer irreversiblen Schädigung der Isolatorschicht. Hierdurch läßt sich das bekannte MOS- Dosimeter elektrisch nicht zurücksetzen, auch kann eine solche MOS-Struktur nicht unmittelbar mit einer Auswerteelektronik verknüpft werden. Die Erfindung vermeidet diese Nachteile dadurch, daß die Isolatorschicht (Siliziumdioxidschicht 2) als strahlenharte Schicht ausgebildet und mit einem floating gate 3 versehen ist. Die strahlenharte Isolatorschicht wird in einem gehärteten Prozess durch thermische, trockene Oxidation ($O_2$) von Silizium bei niederen Temperaturen von ca. 850 bis 950°C durchgeführt.Das erfindungsgemäße MOS- Dosimeter ermöglicht es, sowohl negative als auch positive Ladungen auf dem floating gate 3 zu integrieren. Somit ist es möglich, MOS- Sensoren mit einer signalverarbeitenden Elektronik gemeinsam auf einem Chip zu integrieren. Durch die Einführung eines Konzentrators kann die Empfindlichkeit des erfindungsgemäßen MOS-Dosimeters gegenüber herkömmlichen MOS-Sensoren um mehrere Größenordnungen gesteigert werden.

Fig.6

Hahn-Meitner-Institut für Kernforschung Berlin GmbH

MOS-Dosimeter und Verfahren zu seiner Herstellung

Die Erfindung bezieht sich auf ein MOS-Dosimeter zur Messung der Energiedosis im Bereich von Strahlenfeldern, aus einem Halbleitersubstrat mit einer Isolatorschicht und einem Metallkontakt. Derartige MOS-Dosimeter können insbesondere als Sensoren zur Überwachung strahlenbelasteter Umgebung, z.B. von Kernkraftwerken, als Personendosimeter im Strahlenschutz, an Bord von Weltraumsatelliten und ferner als ortsauflösendes Dosimeter zur Bestimmung der Energiedosis als Funktion von Ort und Zeit verwendet werden.

Das Prinzip eines MOS-Dosimeters ist z.B. aus einem Fachaufsatz " A new direct reading Solid-State Dosimeter" von Ian Thomson vorbekannt ( Canadian Astronautics Limited, 28. Jahreskonferenz der Health Physics Society, Juni 1983, Baltimore, Maryland, USA). Danach werden unter der Einwirkung ionisierender Strahlung im Oxid von MOS-Strukturen Elektron-Loch-Paare generiert. Wenn während der Bestrahlung am Gate -Kontakt der MOS-Struktur eine elektrische Spannung anliegt, so wird im elektrischen Feld des Oxids ein Teil der Elektron-Loch-Paare so schnell räumlich getrennt, daß diese einer Rekombination entgehen. Unter positiver Gate-Spannung verlassen die Elektronen das Oxid über den Gate -Kontakt, während die Löcher zur $Si/SiO_2$-Phasengrenze wandern. Im Bereich dieser Phasengrenze kann ein Teil der bei Raumtemperatur beweglichen Löcher in neutralen Löcherhaftstellen ( Traps) eingefangen werden, so daß eine positive Oxidladung $Q_{fr}$ entsteht. Für die im unteren und im mittleren Dosisbereich ( $D < 50$ krad($SiO_2$)) auftretende Schwellspannungsänderung $\Delta U_{th}$ eines MOS- Transistors

ergibt sich unter Vernachlässigung des Einflusses von Phasengrenzzuständen:

$$\Delta U_{th} = - \frac{\bar{x}}{\varepsilon_o \varepsilon_{SiO_2}} \; A \; K \; f_H \; d_{ox} \; D \qquad (1)$$

Hierbei ist $\varepsilon_o$ die Dielektrizitätskonstante des leeren Raumes, $\varepsilon_{SiO_2}$ die Dielektrizitätskonstante des Oxids und $\bar{x}$ der Ort des Ladungsschwerpunktes. K ist der Ionisationskoeffizient und gibt die generierte Löcherladung pro Volumeneinheit und pro rad $(SiO_2)$ an. Die feldabhängige Ladungsausbeute $f_H$ beschreibt den Anteil der Elektron-Loch-Paare, der nach der Generation nicht rekombiniert. Es gilt

$$0 \leq f_H \leq 1$$

Für die Oxiddicke steht $d_{ox}$ und die absorbierte Dosis wird durch die Größe D angegeben. A gibt den Anteil der Löcher an, die in neutralen Traps eingefangen werden: $0 \leq A \leq 1$.

Aus Gleichung (1) folgt:

$$\Delta U_{th} \sim D \qquad (2)$$

Diese Proportionalität zwischen der absorbierten Dosis D und der Schwellspannungsänderung $\Delta U_{th}$ gilt solange, wie die Anzahl der in neutralen Traps eingefangenen Löcher klein ist verglichen mit der Anzahl an einfangfähigen Löchertraps. Der durch die Beziehung (2) angegebene Zusammenhang macht es möglich, MOS-Varaktoren oder MOS-Transistoren als Dosimeter einzusetzen. Derartige MOS-Dosimeter können als bekannt vorausgesetzt werden .

Bei der Anwendung eines solchen einfachen MOS-Dosimeters bestehen folgende Nachteile. Das Meßprinzip beruht auf einer Schädigung der MOS-Struktur. Diese Schädigung wird durch das Einfangen von Löchern in Traps im Bereich der Si/SiO$_2$ Phasengrenze hervorgerufen und bewirkt neben der gewünschten Änderung der Schwell-spannung $\Delta U_{th}$ auch eine Verschlechterung anderer elektrischer Eigenschaften der MOS- Struktur. So entstehen schnelle und langsame Phasengrenzzustände. Die schnellen Phasengrenzzustände verursachen eine Verringerung der Steilheit des MOS- Transistors und eine Beeinträchtigung der dynamischen Eigenschaften. Die langsamen Phasengrenzzustände bewirken eine Hysterese der C(U)-Kurve, was zu Instabilitäten der Transistor-kennlinie führt. Die Empfindlichkeit ($\Delta U_{th}$/D ) des Dosi-meters wird maßgeblich vom Löchertrappingfaktor A bestimmt und ist von zahlreichen Unwägbarkeiten im MOS- Präparationsprozess abhängig. Ein empfindliches MOS-Dosimeter muß möglichst viele Löcher einfangen können. Dies bedeutet, daß ein "strahlenweiches" Oxid als Isolatorschicht verwendet werden muß, welches bei kleiner Strahlendosis bereits eine hohe positive Ladung aufbaut. Ein solches "strahlenweiches" Oxid wird durch die Strahlung jedoch irreversibel geschädigt, woraus folgt, daß die Kennlinien instabil werden ( langsame Phasengrenzzustände). Das bekannte MOS-Dosimeter läßt sich auf einfachem Wege elektrisch nicht zurücksetzen. Eine Zurücksetzung ist z.B. nur durch eine Hochtemperaturbehandlung möglich, welche jedoch nicht erwünscht ist.

Die genannten Nachteile bekannter MOS-Dosimeter sind auch der Grund dafür, daß es bisher nicht möglich ist, MOS-Dosimeter-Transistoren gemeinsam mit einer signalverarbeitenden Elektronik auf einem Chip zu integrieren, ohne daß eine Schädigung der Signalelektronik in Kauf genommen werden muß. Darüber hinaus ist es bisher nur möglich, negative Verschiebungen der C(U)-Kennlinie auszuwerten, da nur positive Oxidladungen gesammelt werden können.

Der Erfindung liegt von daher die Aufgabe zugrunde, ein MOS-Dosimeter der gattungsgemäßen Art zu schaffen, dessen Wirkungsweise nicht auf einer Materialschädigung beruht, das elektrisch zurücksetzbar ist und das ferner gemeinsam mit einer signalverarbeitenden Elektronik auf einem Chip integriert werden kann, ohne daß eine Schädigung der Signalelektronik zu befürchten ist.

Zur Lösung dieser Aufgabe sieht die Erfindung vor, daß die Isolatorschicht als strahlenharte Schicht ausgebildet und mit einem floating gate versehen ist. Dadurch werden die den bekannten MOS-Dosimetern anhaftenden Nachteile umgangen. Die Sammlung der in der Isolatorschicht generierten Ladung erfolgt auf dem floating gate. Das Löchertrapping in den Traps der Isolatorschicht wird weitgehend dadurch vermieden, daß zwar auch in der strahlenharten Isolatorschicht Elektronen-Loch-Paare erzeugt werden, jedoch kaum Löcher in Traps eingefangen werden. Als neuer Speicher für die positive Ladung wird das floating gate eingesetzt, welches die Ladungen einsammelt, das heißt die positiven und negativen Ladungen. Für die Herstellung der strahlenharten Isolatorschicht wird ein gehärteter Prozess verwendet, so daß eine Verschlechterung der elektrischen Eigenschaften des MOS-Transistors stark reduziert wird. Der "gehärtete Prozess" bedeutet z.B. eine thermische, trockene Oxidation $(O_2)$ insbesondere von Silizium bei niederen Temperaturen von ca. 850 bis 950 °C. Die Empfindlichkeit des Dosimeters wird maßgeblich durch dessen Geometrie bestimmt und ist damit weitgehend unabhängig von Unabwägbarkeiten im MOS-Präparationsprozess. Nach der ionisierenden Bestrahlung kann das erfindungsgemäße MOS-Dosimeter auf seinen Anfangswert zurückgesetzt werden, was eine Eichung des Sensors möglich macht. Da für die Herstellung der strahlenharten Isolatorschicht des Gates ein "gehärteter Prozess" verwendet wird, ist es möglich, die Sensoren mit einer signalverarbeitenden Elektronik gemeinsam auf einem Chip zu integrieren. Somit wird es z.B. auch möglich, ortsauflösende Sensoren herzustellen. Das erfindungsgemäße MOS-Dosimeter ermöglicht es, sowohl negative als auch positive Ladungen auf dem floating gate zu integrieren. Somit ergeben sich positive bzw. negative Verschiebungen der Transistorkennlinie, was die Wahl des Transistortyps (n- oder p-Kanal) freistellt.

Weitere vorteilhafte Ausgestaltungen der Erfindung ergeben sich aus den Unteransprüchen. Insbesondere wird darauf hingewiesen, daß das Halbleitersubstrat für die praktisch bedeutende Ausführungsform des erfindungsgemäßen MOS-Dosimeters Silizium ist, so daß die strahlenharte Isolatorschicht eine Siliziumdioxidschicht ist.

Es sind zwar floating-gate-Transistoren an sich bekannt und auch als Speicherzellen im Einsatz. Jedoch dienen diese nicht dem erfindungsgemäßen Einsatzzweck bei einem MOS-Dosimeter, so daß die Erfindung die Verwendung eines an sich bekannten floating gates zu einem anderen Zweck in Verbindung mit einer strahlenharten Isolatorschicht betrifft.

Die Erfindung ist nachfolgend anhand mehrerer Ausführungsbeispiele von MOS-Dosimetern näher erläutert. Es zeigen:

Fig. 1 und 2a,b die theoretischen Grundlagen eines bekannten MOS-Dosimeters,

Fig. 3 a,b die theoretischen Grundlagen des erfindungsgemäßen MOS- Dosimeters,

Fig. 4 a und b die Schwellspannungsänderung $\Delta U_{th}$
als Funktion des Abstandes $d_2$ für verschiedene Oxiddicken $d_{ox}$,

Fig. 5 die maximale Empfindlichkeit $\Delta U_{th}/ D$
für $d_2 \rightarrow d_{ox}$ als Funktion der Oxiddicke $d_{ox}$,

Fig. 6 eine erste Ausführungsform eines MOS-
Dosimeters,

Fig. 7 eine zweite Ausführungsform,

Fig. 8 eine dritte Ausführungform,

Fig. 9 eine vierte Ausführungsform,

Fig. 10 ein Blockschaltbild eines aus einer Vielzahl von Sensorelementen zusammengesetzten
flächen-auflösenden Dosimeters,

Fig 11a eine Draufsicht auf die fünfte Ausführungsform eines MOS- Dosimeters besonders hoher Empfindlichkeit,

Fig. 11b einen Schnitt gemäß der Line b-b in
Fig.11a,

Fig. 11c die grafische Darstellung des mit dem
MOS-Dosimeters gemäß Fig. 11a,b erzielten
Potentialgradienten,

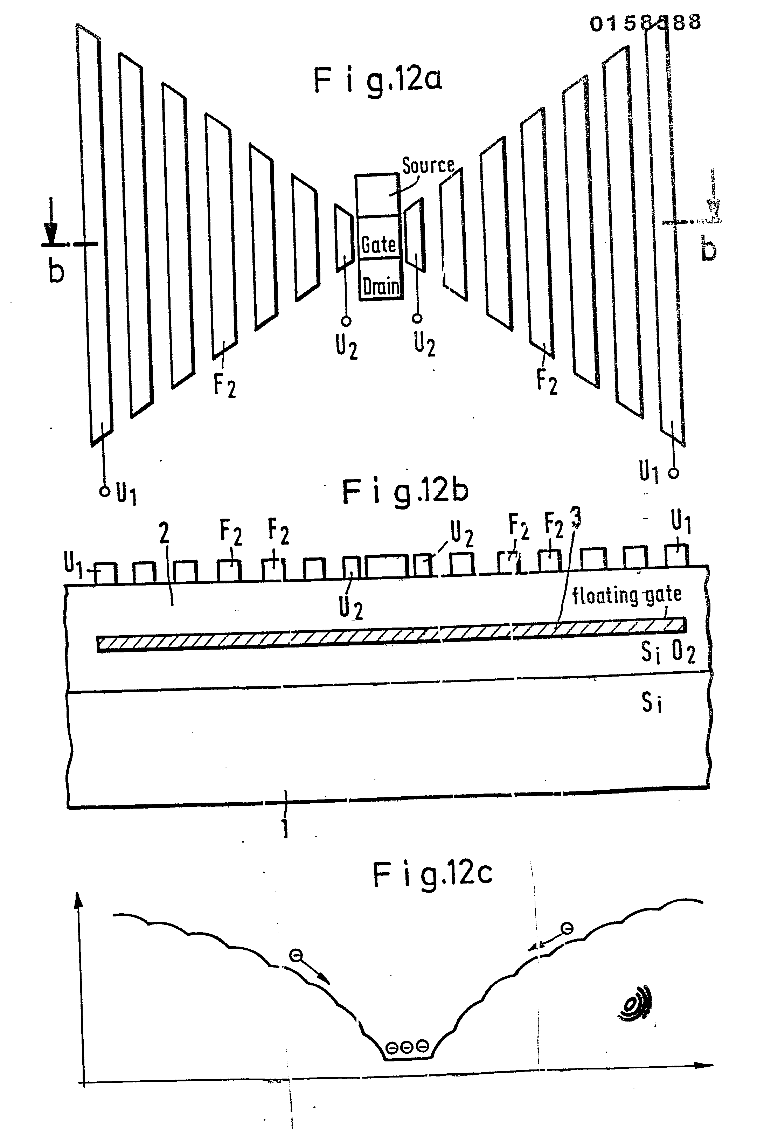

Fig. 12a,b, c   eine der fünften Ausführungsform
entsprechende sechste Ausführungsform
eines MOS- Dosimeters hoher Empfindlichkeit,

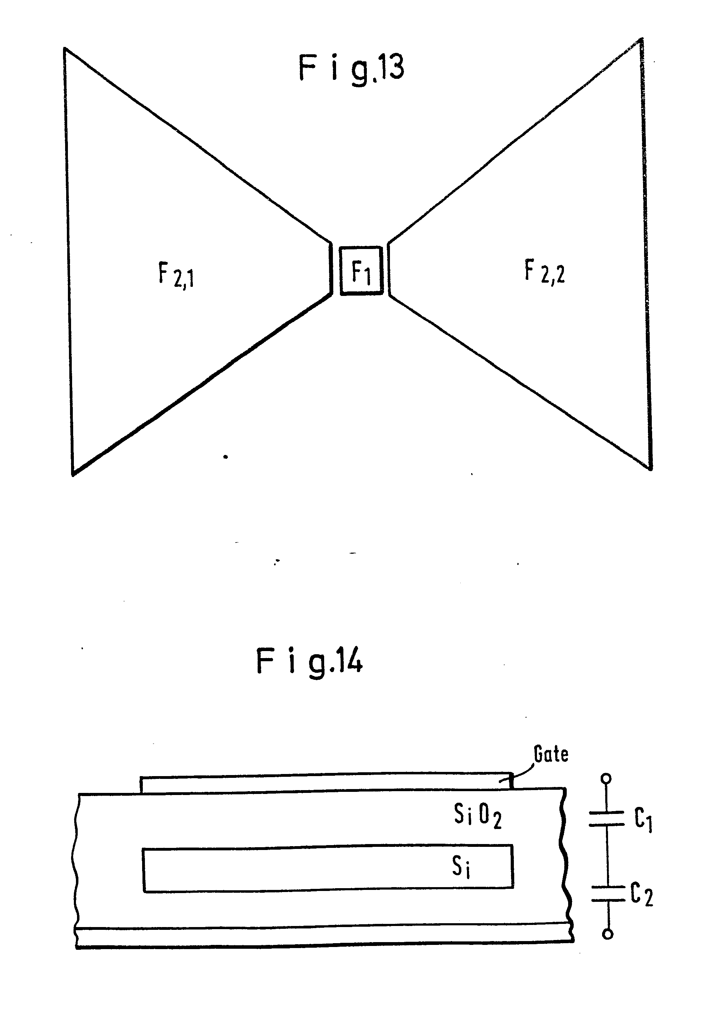

Fig. 13   eine Darstellung des Verhältnisses der
aktiven Sensorfläche $F_2$ zur Transis-
tor- Gatefläche $F_1$ bei den Ausführungsbeispielen gemäß Fig. 11a,b,c und Fig.
12a,b,c und

Fig. 14   eine spezielle Ausführungsform eines
Floating- Substrat-Dosimeters mit zugehörigem Ersatzschaltbild.

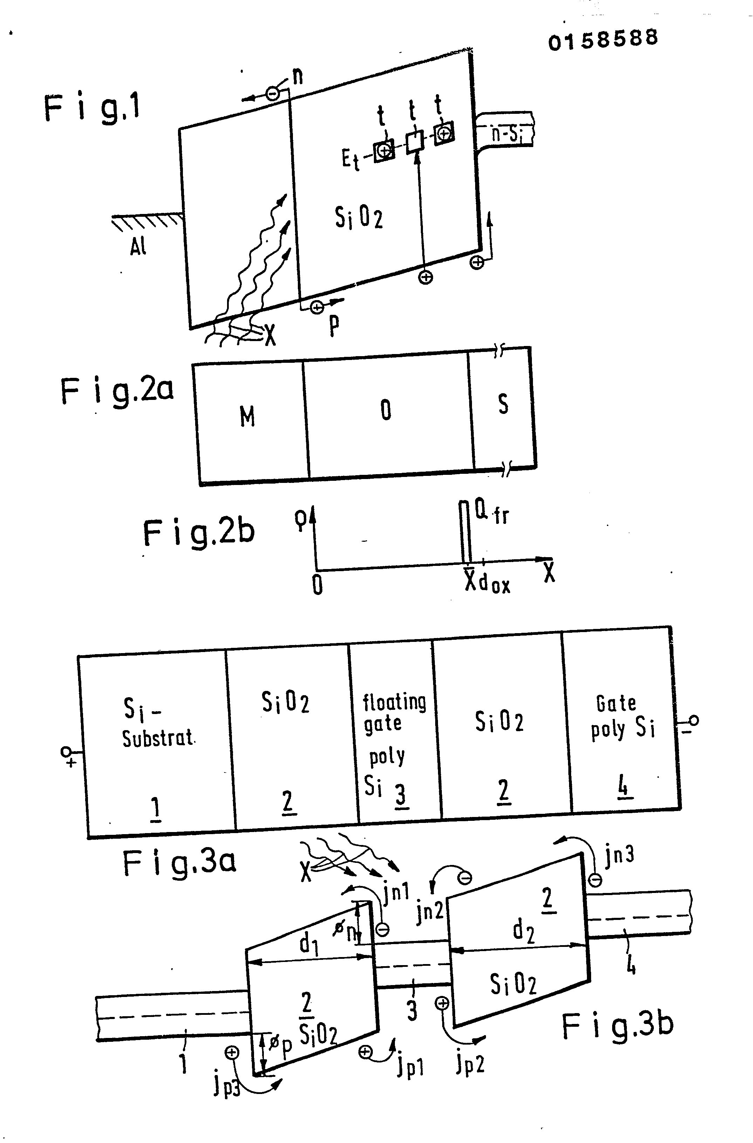

In Fig. 1 und 2 ist der Aufbau eines bekannten MOS-
Dosimeters gezeigt, welches aus einem Silizium-Substrat S
einer Siliziumdioxidschicht O und einer Metallelektrode
M gebildet ist und auf welches eine ionisierende Strahlung X einwirkt. Unter Einwirkung der ionisierenden
Strahlung X werden im Oxid O Elektron- Loch- Paare p und
n erzeugt. Liegt während der Bestrahlung am Gate -Kontakt
M eine elektrische Spannung an, so wird im elektrischen
Feld des Oxids O ein Teil der Elektron-Loch- Paare n,p
so schnell räumlich getrennt, daß diese einer Rekombination entgehen. Unter positiver Gate-Spannung verlassen
die Elektronen n das Oxid O über den Gate-Kontakt M,
während die Löcher zur $Si/SiO_2$-Phasengrenze wandern. Im
Bereich dieser Phasengrenze kann ein Teil der Löcher in
neutralen Traps t eingefangen werden , so daß eine
positive Oxidladung $Q_{fr}$ entsteht. Hierbei entstehen die
einleitend ausführlich abgehandelten Nachteile.

Das erfindungsgemäße MOS-Dosimeter ist in Fig. 3a,b im
Prinzip dargestellt. Dieses besteht aus einem Silizium-

Substrat 1, einer strahlenharten Siliziumdioxidschicht 2 mit einem darin eingebetteten floating gate 3 aus Poly-Silizium oder Metall und einer Elektrode (gate) 3 ebenfalls aus Poly-Silizium oder Metall. In Fig. 3b liegt am Gate 4 eine negative Gatespannung. Wird eine positive Gatespannung angelegt, so erfolgt die anschließende Betrachtung in analoger Weise nach Vorzeichenwechsel von Spannung und Strömen. Die strahlenharte Siliziumdioxidschicht 2 ist z.B. in einem gehärteten Prozess durch thermische, trockene Oxidation ($O_2$) von Silizium bei niederen Temperaturen von ca. 850 bis 950°C gebildet worden. Unter der Einwirkung ionisierender Strahlung X entstehen in der strahlenharten Oxidschicht Elektron-Loch-Paare, was zu Elektronen- und Löcherströmen $j_n$ bzw. $j_p$ führt, wie es in Fig. 3b dargestellt ist. Darüber hinaus fließen Elektronen- und Löcherströme $j_n$ bzw. $j_p$ als Photoströme über die verschiedenen Phasengrenzen der Siliziumdioxidschicht 2. Es fließen folgende Löcherströme :

$j_{p1}$ aus der Oxidschicht 2 auf das floating gate 3, wo dieser gesammelt wird.

$j_{p2}$ aus dem floating gate 3 als Photostrom auf die Oxidschicht 2 , von welcher dieser Löcherstrom abfließt .

$j_{p3}$ aus dem Siliziumsubstrat 1 durch die Oxidschicht 2 auf das floating gate 3, wo dieser Löcherstrom gesammelt wird.

Ferner fließen folgende Elektronenströme:

$j_{n1}$ als Photostrom vom floating gate 3 auf die Oxidschicht 2, von welcher dieser Strom abfließt.

$j_{n2}$ aus der Oxidschicht 2 auf das floating gate 3, wo dieser Strom gesammelt wird.

$j_{n3}$ als Photostrom aus dem Gatekontakt 4 über die Oxidschicht 2 auf das floating gate 3, wo dieser Strom gesammelt wird.

Da in einer strahlenharten Oxidschicht 2 das Ladungstrapping im unteren und mittleren Dosisbereich weitgehend ausgeschlossen werden kann, erfolgt die Ladungssammlung ausschließlich auf dem floating gate 3. Aus diesem Grunde ergibt sich folgende Strombilanz für das floating gate 3.

Die Ladungsänderung auf dem floating gate 3 wird durch die Divergenz der Stromdichte bestimmt.

$$\frac{\delta Q_{fg}}{\delta t} = \text{div } j \qquad (3)$$

Für die Dosimeteranwendungen muß gelten:

$$\frac{\delta Q_{fg}}{\delta t} \neq 0 \implies \text{div } j \neq 0 \qquad (4)$$

Die Ladungsbilanz auf dem floating gate 3 ergibt sich zu

$$Q_{fg}(t) = \int_0^t (j_{p1} + j_{p3} - j_{p2} + j_{n1} - j_{n2} - j_{n3}) \, dt \qquad (5)$$

Bei jeweils gleichen Barrierenhöhen $\phi_P$ und $\phi_n$ am den Phasengrenzen gilt:

$$(j_{n1} = j_{n3}) \qquad (j_{p3} = j_{p2}) \qquad (6)$$

Somit reduziert sich die Gleichung 5 auf die Form der folgenden Gleichung:

$$Q_{fg}(t) = \int_0^t (j_{p1} - j_{n2}) \, dt \qquad (7)$$

Je nach der Größe der Beträge von $j_{p1}$ und $j_{n2}$ sind positive bzw. negative Ladungen auf dem floating gate 3 möglich. Die Größen von $j_{p1}$ und $j_{n2}$ richten sich nach den jeweiligen Generationsvolumen, aus denen diese stammen , es gilt somit:

$$( j_{p1} \sim d_1 ) \text{ und } (j_{n2} \sim d_2)$$

Für die auf dem floating gate 3 gesammelte Ladung $Q_{fg}$ folgt somit:

$$Q_{fg} = Kf_h \; ( d_{ox} - 2d_2) \; D \qquad (8)$$

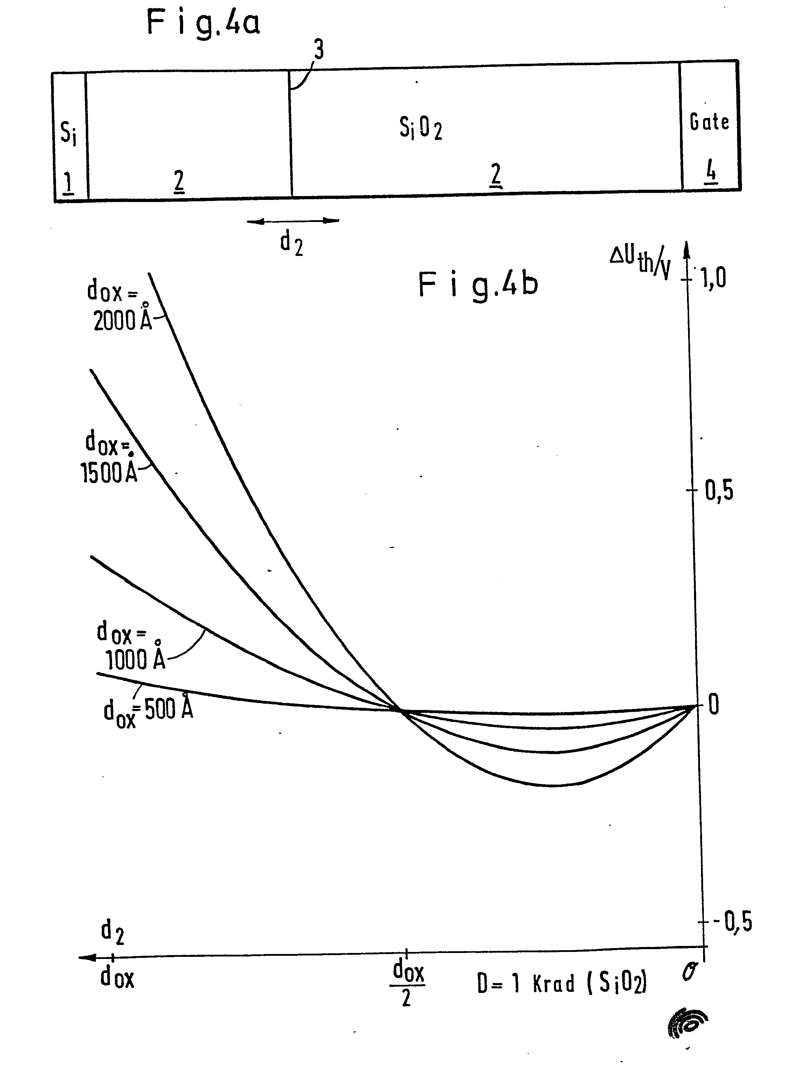

In der Figur 4a ist das MOS-Dosimeter vereinfacht dargestellt. Die Ladung $Q_{fg}$ ist als eine Flächenladung gezeigt, die sich in einem Abstand $d_2$ vom Gatekontakt befindet. Für die Schwellspannungsänderung $\triangle U_{th}$ eines solchen MOS- Transistors gilt:

$$\triangle U_{th} = - \frac{d_2}{\mathcal{E}_o \mathcal{E}_{SiO_2}} \; Q_{fg} \qquad (9)$$

Mit der Gleichung (8) folgt:

$$\triangle U_{th} = - \frac{d_2}{\mathcal{E}_o \mathcal{E}_{SiO_2}} \; Kf_h \; (d_{ox} - 2d_2 ) \; D$$

Die Fig. 4b zeigt die Schwellspannungsänderung $\triangle U_{th}$ als Funktion des Abstandes $d_2$ für verschiedene Dicken $d_{ox}$ der Oxidschicht 2. Es zeigt sich, daß die Empfindlichkeit des MOS- Dosimeters eine Funktion des Abstandes $d_2$ und der Dicke $d_{ox}$ der Oxidschicht 2 ist, wobei der Einfluß der feldabhängigen Ladungsausbeute $f_H$ fü elektrische Felder $F > 1$ MV/cm vernachlässigbar ist.

Die Fig. 4 b wurde rechnerisch dadurch erhalten , daß das floating gate 3 zwischen dem Siliziumsubstrat 1 und dem Gatekontakt 4 von links nach rechts durchgeschoben wurde. Es zeigt sich, daß dann, wenn die Dicken der Oxidschichten 2 gleich groß sind, der Bereich des gezeigten Knotens erreicht ist, welcher meßtechnisch nicht auswertbar ist. Eine besonders hohe Empfindlichkeit wird gemäß Fig. 4b dann erreicht, wenn das floating gate 3 nahe dem Siliziumsubstrat 1 angeordnet ist.

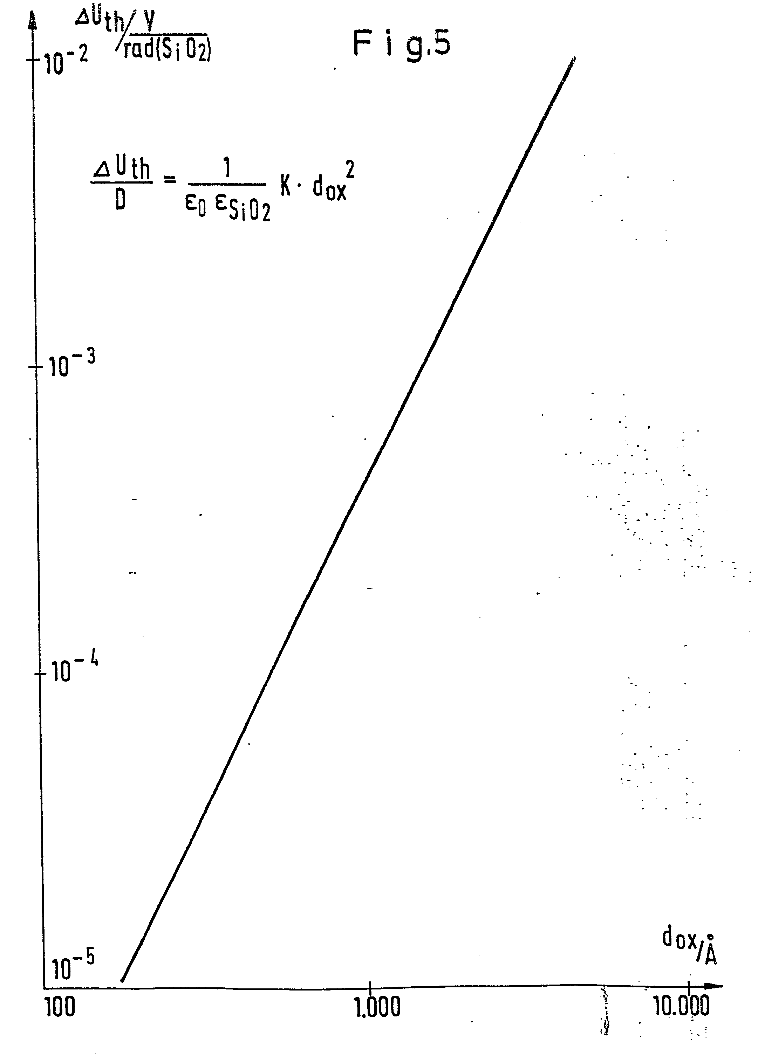

Die Fig. 5 zeigt die maximale Empfindlichkeit ( $\triangle U_{th}/D$) für $d_2 \longrightarrow d_{ox}$ als Funktion der Dicke $d_{ox}$ der Oxidschicht 2 . Dieser maximalen Empfindlichkeit entspricht die größte theoretische Empfindlichkeit des einfachen MOS-Dosimeters nach Fig.2.

Nach der Bestrahlung des MOS- Dosimeters mittels ionisierender Strahlung X ist es möglich, die aufgebaute Oxidladung $Q_{fg}$ vom floating gate 3 zu entfernen. Hierzu gibt es zwei Möglichkeiten:

1. Es erfolgt eine Bestrahlung des MOS- Dosimeters unter entgegengesetzter Gatespannung. Hierbei werden Ladungen entgegengesetzten Vorzeichens auf das floating gate 3 gebracht.

2. Die Entfernung der Oxidladung erfolgt durch Avalanche Injection, wobei aus dem Silizium - Substrat 1 Elektronen auf das floating gate 3 gelangen und dort eine positive Ladung kompensieren können.

Bei Sonderfällen der Ausführung des MOS- Dosimeters wird darauf hingewiesen, daß die Größe der unter ionisierender Strahlung X generierten Ladung auf dem floating gate 3 nach der Gleichung 7 durch die Stromdichte Differenz ( $j_{p1} - j_{n2}$) gegeben wird. Diese Stromdichten sind proportional zu den Generationsvolumen aus denen diese stammen. Es ist also nicht nur möglich, die aus der Differenz ($j_{p1}-j_{n2}$) resultierende Ladung $Q_{fg}$ durch die Größe $d_2$ zu verändern. Ebenso können die beiden Generationsvolumen durch eine Flächenänderung beeinflußt werden. Hierbei muß allerdings die durch den kapazitiven Spannungsteiler verursachte Feldstärkedifferenz in den beiden Generationsvolumen berücksichtigt werden. Unterschiedliche Generationsraten in den beiden Generationsvolumen können auch durch unterschiedliche Materialien mit $K_1 \neq K_2$ hervorgerufen werden.

Nachfolgend werden verschiedene Ausführungsformen eines erfindungsgemäßen MOS- Dosimeters als technologische Realisierungsmöglichkeiten näher erläutert. Die im folgende beschriebenen Ausführungsformen sind für die Silizium-Technologie angegeben. Prinzipiell können aber auch andere Materialien verwendet werden.

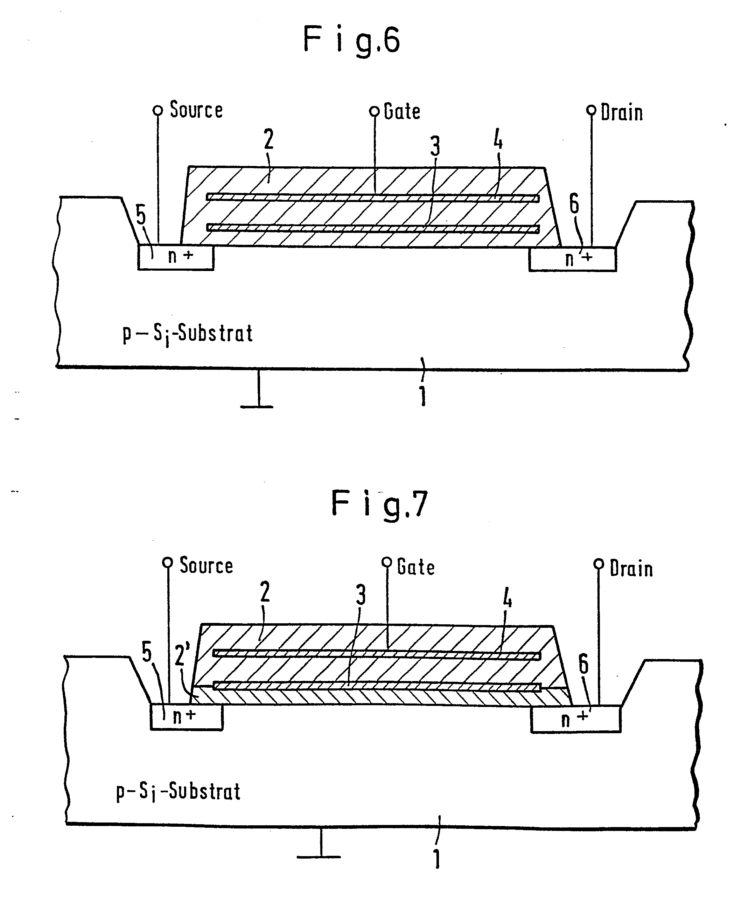

Die Fig. 6 zeigt die erste Ausführungsform des MOS-Dosimeters. Dieses besteht aus dem Siliziumsubstrat 1 und einer darauf im "gehärteten Prozess" ausgebildeten Siliziumdioxidschicht 2, in welche übereinander das floating gate 3 und die Gate - Elektrode 4 eingebettet sind. Das Silizium- Substrat 1 ist p-leitend. n-leitende Anschlüsse 5 und 6 dienen als Source- bzw. Drain-Elektroden. Der Aufbau dieses MOS- Dosimeters entspricht im wesentlichen dem eines FAMOS-Transistors.* Allerdings ist für die Herstellung der Siliziumdioxidschicht 2 ein "gehärteter Prozess" angewendet worden, welcher als thermische trockene Oxidation ($O_2$) von Silizium bei niederen Temperaturen von ca. 850 bis 950°C ausgeführt wird. (*Solid-State Elect.1974 Vol.17, pp.517-529.Pergamon Press.GB )

Die Fig. 7 zeigt einen MOS-Dosimeter-Transistor mit unterschiedlichen Isolatormaterialien 2 und 2', zwischen welchen das floating gate 3 eingebettet ist . In die zweite Isolatorschicht 2 ist die Gate- Metallelektrode 4 eingebettet. Source- und Drain-Elektroden 5 , 6 sind in gleicher Weise wie beim ersten Ausführungsbeispiel gemäß Fig. 6 beim zweiten Ausführungsbeispiel gemäß Fig. 7 angeordnet .

Bei beiden Ausführungsformen wird ein Poly-Siliziumfloating- gate 3 sowie ein Poly-Slizium-Gatekontakt 4 verwendet. Bei der Ausführungsform gemäß
Fig. 7 sind unterschiedliche Isolatormaterialien
2, 2' vorgesehen, deren Ionisationskoeefizienten K
unterschiedlich sind .

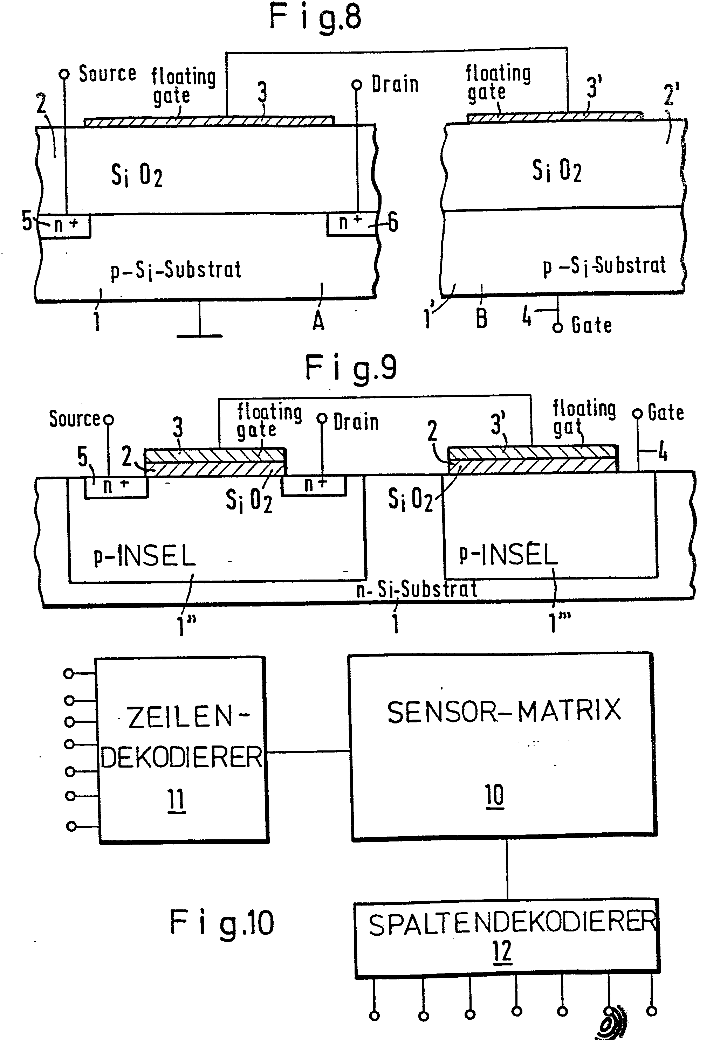

Die in den Fig. 6 und 7 dargestellten vertikalen Strukturen der ersten und zweiten Ausführungsform eines
MOS- Dosimeters lassen sich auch zerlegen, wie es in
der dritten und vierten Ausführungsform gemäß den Fig. 8
bzw. 9 gezeigt ist. Die Fig. 8 zeigt eine MOS- Dosimeter-Struktur unter Verwendung von zwei Chips A,B. Der
Chip A besteht aus einem p-Siliziumsubstrat 1 mit aufgebrachter Siliziumdioxidschicht 2 und floating gate 3
und umfaßt ferner die Source-und Drain-Elektroden 5
bzw. 6. Der Chip B besteht aus dem p-Silizium- Substrat
1' mit Siliziumdioxidschicht 2' und floating gate 3'.
Die floating gates 3,3' sind elektrisch leitend miteinander verbunden. Als Gatekontakt 4 wird hier das p-
Silizium-Substrat 1' des Chips B verwendet. Es besteht
auch die Möglichkeit, beide floating- gate- Kontakte
3,3' in unterschiedlichen Größen auszuführen, um die
gewünschte Empfindlichkeit des MOS- Dosimeters zu erreichen.
Die gezeigte Ausführungsform wird mit einer strahlenharten
Passivierungsschicht überzogen oder in ein evakuiertes
Gehäuse eingebaut.

Bei der vierten Ausführungsform des MOS- Dosimeters
gemäß Fig. 9 ist die in Fig. 8 bereits dargestellte
Anordnung auf einem einzigen Chip aus einem n-Silizium-
Substrat 1 integriert. Dieses weist zwei p-Inseln 1''
und 1''' auf, welche jeweils mit einer Siliziumdioxidschicht
2,2' sowie je einem floating gate 3,3' versehen sind,
welche elektrisch leitend miteinander verbunden sind.

0158588

Die Source- und Drain-Elektroden 5,6 sind auf der
einen p- Insel 1'' vorgesehen, wohingegen der Gatekontakt 4 an die andere p-Insel 1'''angeschlossen ist.

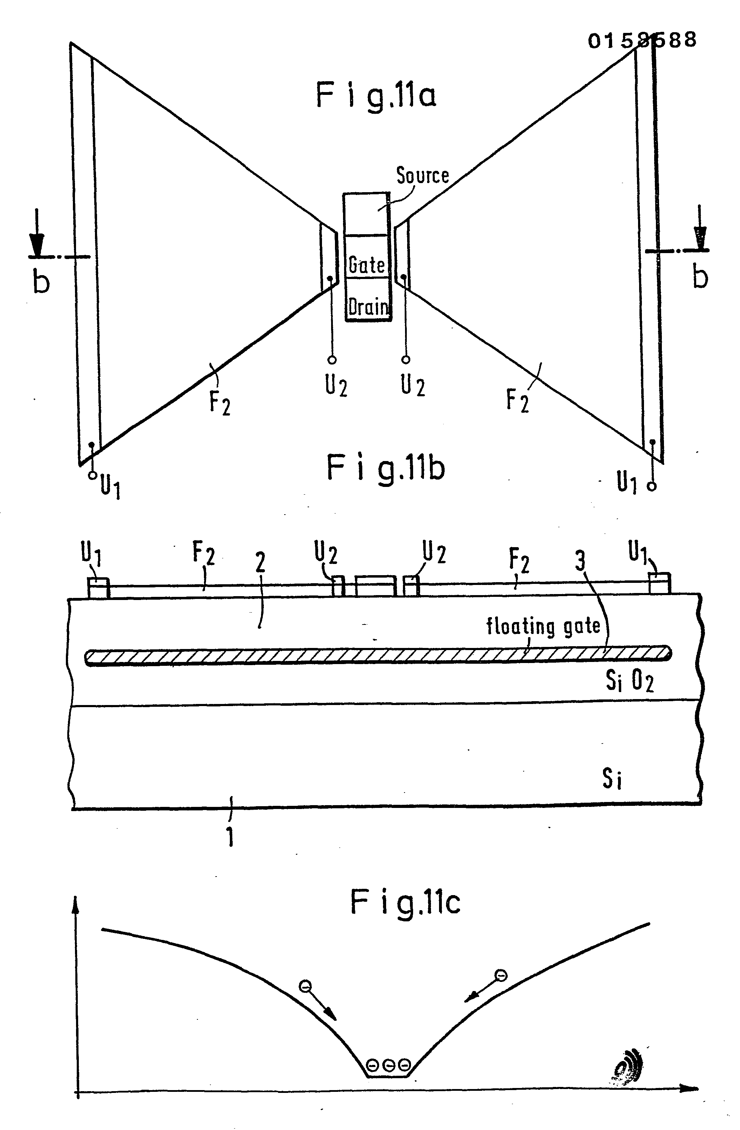

Gemäß dem in Fig. 10 dargestellten fünften Ausführungsbeispiel kann eine Vielzahl von Sensorelementen in einer
Sensor- Matrix 10 vereinigt und gemeinsam auf einem Chip
integriert werden. Die Sensor-Matrix 10 ist mit einem
Zeilendecodierer 11 und einem Spalten- Decodierer 12 verbunden. Somit ist es möglich, flächenauflösende MOS-
Dosimeter zur realisieren, wie es das Blockschaltbild
gemäß Fig. 10 zeigt.

Es werden nachfolgend zwei Ausführungsbeispiele des
MOS- Dosimeters beschrieben, bei welchen eine Erhöhung
der Empfindlichkeit mittels des floating gates 3 erreicht
werden kann. Die maximale Empfindlichkeit für ein MOS-
Dosimeter liegt bei $\Delta U_{th}/D \approx 1mV/rad$ $(SiO_2)$ für $d_{ox}=$
$1000 A^O$. Wie es Fig. 5 zeigt, kann diese Empfindlichkeit
durch eine Vergrößerung der Dicke $d_{ox}$ der Oxidschicht 2, d.h.
des Generationsvolumens, gesteigert werden. Einer solchen
Vergrößerung der Oxiddicke sind allerding technologische
Grenzen gesetzt. Das Generationsvolumen kann auch dadurch
erhöht werden, daß die Sensorfläche vergrößert wird. Dies
führt allerdings nicht zu einer Erhöhung der Empfindlichkeit,
da die Schwellspannungsänderung $\Delta U_{th}$ eine Funktion der
auf dem floating gate 3 gesammelten Flächenladungsdichte
ist, welche aus Gleichung 9 resultiert.

Eine Erhöhung der Dosimeterempfindlichkeit kann erfindungsgemäß durch eine Konzentration der generierten Ladung
erreicht werden. Dabei wird die unter einer Fläche $F_2$
generierte Ladung unter einer Fläche $F_1$konzentriert, wobei
gilt: $F_1 < F_2$. Dabei kommt es unter der Fläche $F_1$
zu einer Erhöhung der Flächenladungsdichte. Praktisch
wird dieser Konzentratoreffekt dadurch erzielt, daß auf dem floating gate 3 ein Potentialgradient erzeugt wird.

In den Fig. 11 und 12 sind zwei Ausführungsformen dargestellt, bei welchen ein solcher Potentialgradient durch Spannungsabfall an hochohmigem Gatematerial ( Fig.11) bzw. durch kapazitive Spannungsteilung an einer unterbrochenen Gate- Struktur (Fig. 12) entsteht. Durch kapazitive Kopplung spiegelt sich der Potentialgradient auf dem floating gate wieder . Die auf den floating gates 3 gesammelten Ladungen , z. B. Elektronen fließen in die Potentialmulde ( Fig.11c und 12c ) und werden dort konzentriert. Der Ladungstransferprozess läßt sich durch die Kontinuitätsgleichung 11 beschreiben:

$$\frac{\delta n}{\delta t} = \frac{\delta}{\delta x}\left\{\mu_\eta n \; E(x,t) + D_n \frac{\delta n}{\delta x}\right\} \quad (11)$$

Hierbei treten zwei treibende Mechanismen auf:

a) Das elektrische Feld $E(x,t)$, das aus den erzeugten Potentialgradienten und dem durch die Ladung selbst induzierten Feld selbst besteht.

b) Der Konzentrationsgradient der Ladung auf den floating gates 3.

Bei Zunahme der gespeicherten Ladung wird das Silizium-Oberflächenpotential beeinflußt und die Potentialmulde abgeflacht. Dadurch nimmt die Konzentratorwirkung bei zunehmender Ladung ab. Da ein Konzentratoreinsatz nur im Bereich kleiner Dosen, d.h. kleiner Speicherladungen sinnvoll ist, verliert das Problem an Bedeutung. Die exakte mathematische Behandlung des Ladungstransfers und der"Charge-Handling-Capability" ist aus der Technik der ladungsgekoppelten Bauelemente (CCD) bekannt. Hierbei werden simultan die Kontinuitätsgleichung und die Poissongleichung numerisch gelöst.

Die Erhöhung der Dosimeterempfindlichkeit durch Ladungs-konzentration ergibt sich zu:

$$\frac{\triangle U^*_{th}}{D} = M \cdot \frac{\triangle U_{th}}{D} \qquad (12)$$

$\triangle U^*_{th}$ ist die Empfindlichkeit mit und $\triangle U_{th}$ die Empfindlichkeit ohne Konzentrator. Der Konzentrator-Parameter M ergibt sich aus dem Verhältnis der aktiven Sensorfläche $F_2$ zur Transistorgatefläche $F_1$, welche in Fig. 13 dargestellt sind. Bei einer Sensorfläche $F_2 = 1cm^2$ und einer Transistorgatefläche $F_1 = 10^{-6} cm^2$ ergibt sich ein Konzentratorparameter $M = 10^6$. Dies führt zu einer Dosimeterempfindlichkeit von ca $1V/10^{-3}$ rad ( $SiO_2$).

Gemäß Fig. 11a,b wird auf die Siliziumdioxidschicht 2 einerseits eine hochohmige , trapezförmige Widerstands-fläche $F_2$ in symmetrischer Form aufgebracht, in deren Randzonen zwei niederohmige Anschlüsse zum Anlegen einer Spannung $U_1$ , $U_2$ angebracht sind . Auf der hochohmigen Schicht $F_2$ ergibt sich ein Potentialgefälle zwischen den Werten $U_1$ und $U_2$ . Durch kapazitive Kopplung spiegelt sich der Potentialgradient auf dem floating gate wieder . Ladungen (z.B. Elektronen ) , die sich auf dem floating gate gesammelt haben , fließen in die entstandene Potentialmulde . Dadurch wird die Flächenladungsdichte unter der Transistorgatefläche und damit der Einfluß auf die Transistorkennlinie erhöht . Dieser Konzen-tratoreffekt wird duch ein Potentialgefälle auf mindestens einer Widerstandsschicht $F_2$ geschaffen , deren Form - im Ausführungsbeispiel Trapezform - nicht vorrangig ist .

Im Ausführungsbeispiel gemäß Fig. 12a,b wird die große Fläche $F_2$ der hochohmigen Widerstandsschicht durch Streifen aus Metall oder Poly- Silizium ersetzt, d.h.

durch eine parallel zueinander verlaufende Leiterstruktur mit den Einzelflächen $F_2$,. Durch kapazitive Spannungsteilung bildet sich aufgrund der Streifenstruktur zwischen diesen und dem floating gate 3 das gewünschte Spannungsgefälle aus, welche die in Fig. 12c dargestellte Konzentration der gesammelten Ladungen in der Potentialmulde bewirkt.

In Fig. 14 ist noch eine Sonderausführung des MOS-Dosimeters gezeigt. Hierbei wird durch Abmagerung aus dem floating- gate-Dosimeter ein floating- Substrate-Dosimeter, für welches in Fig. 14 auch das zugehörige Ersatzschaltbild gezeigt ist. Durch Ladungsansammlung auf dem Substrat kommt es zu einer elektrischen Aufladung der Rückseitenkapazität $C_2$ und dadurch zu einer Verschiebung der Schwellspannung$\Delta U_{th}$. Für das floatende Substrat gelten die gleichen Bedingungen wie für ein floating gate.

Die in den Ausführungsbeispielen der Figuren 8,9 und 14 angegebenen "floating-gate"-Konfigurationen lassen sich im konventionellen MOS-Prozeß durch Aufdampfen einer Metallschicht (z.B. Al,Au u.s.w.) oder durch Abscheidung (CVD) einer polykristallinen Siliziumschicht herstellen . Dieses Konzept ist voll kompatibel mit einem "strahlenharten " Präparationsprozeß .

Die Einbettung eines"floating-gate" gemäß Figur 6 kann wie folgt geschehen :
Auf eine thermisch oxodierte $SiO_2$-Schicht wird das Material für das "floating-gate" aufgebracht , wie es oben ausgeführt worden ist . Anschließend wird die Anordnung mit einer $SiO_2$-Schicht überzogen , die durch CVD erzeugt wird .

Hahn- Meitner-Institut für Kernforschung Berlin GmbH

Patentansprüche

1. MOS- Dosimeter zur Messung der Energiedosis im Bereich von Strahlenfeldern, aus einem Halbleitersubstrat mit einer Isolatorschicht und einem Metall-oder Poly-Siliziumkontakt, d a d u r c h   g e k e n n z e i c h n e t , daß die Isolatorschicht als strahlenharte Schicht (2) ausgebildet und mit einem floating gate (3) versehen ist.

2. MOS- Dosimeter nach Anspruch 1, dadurch gekennzeichnet, daß das floating gate in das Isolatormaterial (2) eingebettet ist.

3. MOS-Dosimeter nach Anspruch 1 , dadurch gekennzeichnet, daß das floating gate (3) als Grenzschicht zwischen zwei unterschiedlichen Isoliermaterialien (2,2') eingebettet ist.

4. MOS- Dosimeter nach einem der Ansprüche 1 bis 3, dadurch gekennzeichnet, daß zwei aus Halbleitersubstrat (1,1'), Isolatorschicht (2,2') und floating gate (3,3') gebildete Chips (A,B) vorgesehen und die floating gates (3,3') der beiden Chips (A,B) leitend miteinander verbunden sind und daß das Halbleitersubstrat (1') des einen Chips (B) als Gate-Kontakt (4) geschaltet ist.

5. MOS-Dosimeter nach einem der Ansprüche 1 bis 3, dadurch gekennzeichnet, daß ein Chip aus Halbleiter-Substrat (1) und zwei gegendotierten Substratmaterial-Inseln (1'',1''') und darauf befindlichen Isolatorschichten (2,2') mit je einem floating gate (3,3') ausgebildet ist, wobei die floating gates (3,3') miteinander leitend verbunden sind und eine Substratmaterial-Insel (1''') als Gate-Kontakt (4) geschaltet ist.

6. MOS- Dosimeter nach einem der Ansprüche 1 bis 5, dadurch gekennzeichnet, daß mindestens eine auf der Isolatorschicht (2) ausgebildete Widerstandsschicht($F_2$) zur Erzeugung eines Potentialgefälles auf dem floating gate (3) vorgesehen ist.

7. MOS- Dosimeter nach Anspruch 6, dadurch gekennzeichnet, daß die Fläche der Widerstandsschicht($F_2$) trapezförmig ausgebildet ist.

8. MOS- Dosimeter nach Anspruch 7, dadurch gekennzeichnet, daß die Widerstandsschicht($F_{2'}$) streifenförmig ausgebildet ist.

9. MOS- Dosimeter nach einem der Ansprüche 6 bis 8, dadurch gekennzeichnet, daß zwei trapezförmige Widerstandsschichten($F_2$,$F_{2'}$) vorgesehen sind, deren schmale Seiten gegeneinander gerichtet sind.

10. MOS- Dosimeter nach einem der Ansprüche 1 bis 9, dadurch gekennzeichnet, daß das Halbleitersubstrat (1) Silizium und die Isolatorschicht (2) eine Siliziumdioxidschicht sind.

11. Verfahren zur Herstellung eines MOS-Dosimeters zur Messung der Energiedosis im Bereich von Strahlenfeldern , aus einem Halbleitermaterial mit einer Isolatorschicht und einem Metall- oder Poly-Siliziumkontakt , d a d u r c h   g e k e n n z e i c h n e t ,

0158588

daß die strahlenharte Schicht ( 2 ) des Siliziumoxids
in einem gehärteten Prozess durch thermische, trockene
Oxidation ($O_2$) von Silizium bei niederen Temperaturen
von ca. 850 bis 950 °C hergestellt wird.

**Fig.1**

**Fig.2a**

**Fig.2b**

**Fig.3a**

**Fig.3b**

# Fig.4a

| $S_i$ | | $S_iO_2$ | | Gate |
|---|---|---|---|---|
| $\underline{1}$ | $\underline{2}$ | | $\underline{2}$ | $\underline{4}$ |

$d_2$

# Fig.4b

$d_{ox} = 2000\,\text{Å}$

$d_{ox} = 1500\,\text{Å}$

$d_{ox} = 1000\,\text{Å}$

$d_{ox} = 500\,\text{Å}$

$\Delta U_{th}/V$

1,0

0,5

0

-0,5

$\dfrac{d_2}{d_{ox}}$

$\dfrac{d_{ox}}{2}$

$D = 1\ \text{Krad}\ (S_iO_2)$

Fig.5

$$\frac{\Delta U_{th}}{D} = \frac{1}{\epsilon_0\,\epsilon_{SiO_2}}\,K\cdot d_{ox}^{\,2}$$

# Fig.6

Source  Gate  Drain

2  3  4

5  6

n +  n +

p−Si−Substrat

1

# Fig.7

Source  Gate  Drain

2  3  4

5  2'  6

n +  n +

p−Si−Substrat

1

## Fig.8

## Fig.9

## Fig.10

Fig.11a

0158588

Source

Gate

Drain

b

b

U₂  U₂

F₂        F₂

U₁        U₁

Fig.11b

U₁    F₂    2    U₂    U₂    F₂    3    U₁

floating gate

Si O₂

Si

1

Fig.11c

F i g.12a

F i g.12b

F i g.12c

# F i g.13

F$_{2,1}$    F$_1$    F$_{2,2}$

# F i g.14

Gate

SiO$_2$    C$_1$

Si    C$_2$